(19) Europäisches Patentamt
European Patent Office
Office européen des brevets

(11) EP 2 562 838 A1

(12) **EUROPEAN PATENT APPLICATION**
published in accordance with Art. 153(4) EPC

(43) Date of publication:
**27.02.2013 Bulletin 2013/09**

(21) Application number: **11772031.8**

(22) Date of filing: **20.04.2011**

(51) Int Cl.:
***H01L 51/50*** *(2006.01)* ***C08G 61/10*** *(2006.01)*
***C09K 11/06*** *(2006.01)*

(86) International application number:
**PCT/JP2011/059688**

(87) International publication number:
**WO 2011/132698 (27.10.2011 Gazette 2011/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.04.2010 JP 2010096728**

(71) Applicant: **Sumitomo Chemical Company, Limited**
**Tokyo 104-8260 (JP)**

(72) Inventor: **IWASAKI, Masataka**
**Tsukuba-shi, Ibaraki 305-0045 (JP)**

(74) Representative: **Duckworth, Timothy John**
**J A Kemp**
**14 South Square**
**Gray's Inn**
**London WC1R 5JJ (GB)**

(54) **ORGANIC LIGHT-EMITTING ELEMENT**

(57) An object of the invention is to provide an organic light emitting device having a high current density at the time of driving. A means for achieving the object is an organic light emitting device which has an anode and a cathode, has between the anode and the cathode a light emitting layer containing a light emitting organic compound, and has between the anode and the light emitting layer a first functional layer containing a first organic compound, a second functional layer containing a second organic compound and a hole transport layer in this order from the anode side, wherein the first organic compound is an electron accepting organic compound, and the second organic compound is an organic compound having a fused ring or not less than three aromatic rings.

Figure 1

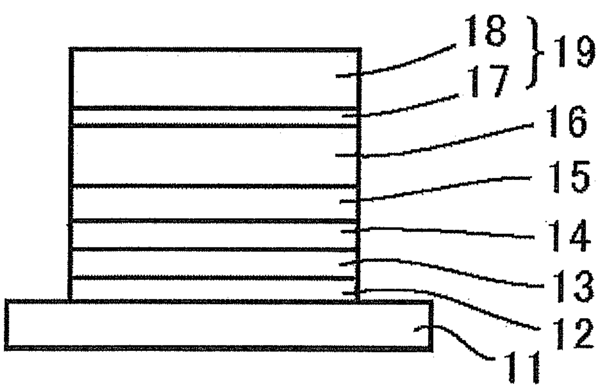


EP 2 562 838 A1

**Description**

TECHNICAL FIELD

The present invention relates to an organic light emitting device, and particularly to an organic light emitting device containing an organic compound having fused ring or a plurality of aromatic rings.

BACKGROUND ART

In recent years, an organic light emitting display using an organic light emitting device has been attracting attention. The organic light emitting device used in the organic light emitting display is a device having an anode, a cathode, and a layer disposed between the anode and the cathode and containing a light emitting organic compound. In the organic light emitting device, an electron supplied from the cathode and a hole supplied from the anode are bound with each other in the light emitting organic compound, and the energy generated with the binding is extracted to outside the device as light.

As an example of the organic light emitting device, an organic light emitting device in which the light emitting organic compound is a light emitting polymer compound (hereinafter referred to as a "polymer light emitting device" in some cases") is known. The polymer light emitting device is advantageous for enlargement of the area and reduction of costs because a light emitting layer can be conveniently formed by wet coating.

It is an object in the art of organic light emitting device that the emission brightness is made to improve. It is effective to enlarge the current density to drive an organic light emitting device for improving the emission brightness, and it is preferred to improve the hole injection efficiency from an anode to a light emitting layer.

As a mean for improving the hole injection efficiency from an anode to a light emitting layer, it has been known that a hole injecting layer is formed in contact with the anode between the anode and the light emitting layer, and it has been reported an organic light emitting device which has a layer containing poly(3,4-ehtylene dioxy thiophene styrene sulfonate) in contact with the anode so that the hole injection from the anode is made to easy (non-patent document 1).

It also has been reported an organic light emitting device which has a thin film of tetracyanoquinodimethane, an electron accepting organic compound, in contact with the anode so that the hole injection from the anode is made to easy (patent document 1).

BACKGROUND ART DOCUMENTS

PATENT DOCUMENTS

Patent Document 1: JP 2001-21104 A

NON-PATENT DOCUMENTS

Non-patent Document 1: Appl. Phys. Lett., 84 (2004), pp. 921

SUMMARY OF THE INVENTION

PROBLEMS TO BE SOLVED BY THE INVENTION

However, the conventional organic light emitting devices described above have a low current density at the time of driving.

It is an object of the present invention to provide an organic light emitting device having a high current density at the time of driving.

MEANS FOR SOLVING THE PROBLEMS

The present invention provides an organic light emitting device which has an anode and a cathode, has between the anode and the cathode a light emitting layer containing a light emitting organic compound, and has between the anode and the light emitting layer a first functional layer containing a first organic compound, a second functional layer

containing a second organic compound and a hole transport layer in this order from the anode side, wherein the first organic compound is an electron accepting organic compound, and the second organic compound is an organic compound having a fused ring or not less than three aromatic rings.

In one embodiment, the second organic compound has a fused ring in which not less than four benzene rings are fused.

The present invention also provides an organic light emitting device, which has an anode and a cathode, has between the anode and the cathode a light emitting layer containing a light emitting organic compound, and has between the anode and the light emitting layer a first functional layer containing a first organic compound and a second functional layer containing a second organic compound in this order from the anode side, wherein the first organic compound is an electron accepting organic compound, and the second organic compound is an organic compound having a fused ring in which not less than four benzene rings are fused.

In one embodiment, the electron accepting compound has a cyano group, a halogen group or a nitro group.

In one embodiment, the electron accepting compound is a quinine derivative.

In one embodiment, the second organic compound is pentacene.

In one embodiment, the light emitting organic compound is a light emitting polymeric compound.

In one embodiment, the hole transport layer contains a polymeric compound having a repeating unit represented by a formula:

[Chemical Formula 1]

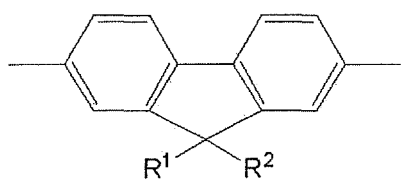

(1)

wherein $R^1$ and $R^2$ are the same or different and each represent an alkyl group, an aryl group that may have a substituent, or a monovalent heterocyclic group that may have a substituent; and a repeating unit represented by formula:

[Chemical Formula 2]

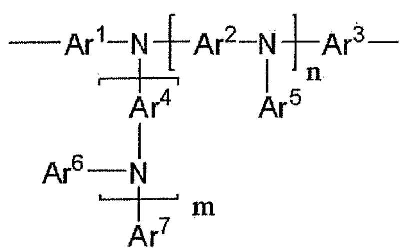

(2)

wherein $Ar^1$, $Ar^2$, $Ar^3$ and $Ar^4$ are the same or different and each represent an arylene group that may have a substituent, or a divalent heterocyclic group that may have a substituent, $Ar^5$, $Ar^6$ and $Ar^7$ each represent an aryl group that may have a substituent, or a monovalent heterocyclic group that may have a substituent, and n and m are the same or different and each represent 0 or 1; and when n is 0, a carbon atom contained in $Ar^1$ and a carbon atom contained in $Ar^3$ may be bonded to each other directly or may be bonded via an oxygen atom or a sulfur atom.

## EFFECTS OF THE INVENTION

An organic light emitting device of the present invention is excellent in hole injection efficiency from an anode

to a light emitting layer, and has a high current density at the time of driving.

BRIEF DESCRIPTION OF THE DRAWING

Fig. 1 is a schematic cross-sectional view showing a structure of an organic electroluminescence device (organic EL device) that is one embodiment of the present invention.

EMBODIMENTS OF THE INVENTION

1. Structure of Device

In one embodiment, an organic light emitting device of the present invention has a cathode and an anode, and has a light emitting layer containing a light emitting organic compound between the cathode and the anode. The organic light emitting device further has between the anode and the light emitting layer a first functional layer containing a first organic compound, a second functional 'layer containing a second organic compound and a hole transport layer in this order from the anode side.

The first functional layer and the second functional layer enhance the function of the hole transport layer, and work so as to improve the hole injection efficiency form the anode to the light emitting layer. In a preferred embodiment, the first functional layer is a hole injection layer. In another preferred embodiment, the second functional layer is a hole transport layer.

The organic light emitting device of the present invention may further include an optional component. For example, the organic light emitting device may optionally have an interlayer between the light emitting layer and the hole transport layer.

The hole injection layer refers to a layer having a function of being injected with a hole from an anode. The hole transport layer refers to a layer having any of a function of transporting a hole, a function of supplying a hole to a light emitting layer, and a function of blocking an electron injected from a cathode. The interlayer has at least one of a function of being injected with a hole from an anode, a function of transporting a hole, a function of supplying a hole to a light emitting layer, and a function of blocking an electron injected from an anode, is normally disposed adjacent to a light emitting layer, and has a role of isolating a light emitting layer from an anode, or a light emitting layer from a hole injection layer or a hole transport layer.

On the other hand, the organic light emitting device may optionally have an electron injection layer between the anode and the light emitting layer and further have one or more of an electron transport layer and a hole blocking layer between the light emitting layer and the electron injection layer (if the electron injection layer is present) or the cathode (if the electron injection layer is absent).

Here, the anode is an electrode which supplies a hole to the hole injection layer, the hole transport layer, the interlayer, the light emitting layer and so on, and the cathode is an electrode which supplies an electron to the electron injection layer, the electron transport layer, the hole blocking layer, the light emitting layer and so on.

The light emitting layer refers to a layer which has a function of being capable of being injected with a hole from a layer adjacent on the anode side and being capable of being injected with an electron injected from a layer adjacent on the cathode side, a function of moving injected charges (electron and hole) by means of a force of an electric field, and a function of providing a site where an electron and a hole are to be bound with each other and leading the binding to light emission when an electric field is applied.

The electron injection layer refers to a layer having a function of being injected with an electron from a cathode. The electron transport layer refers to a layer having either of a function of transporting an electron and a function of blocking a hole injected from an anode. The hole blocking layer refers to a layer which has principally a function of blocking a hole injected from an anode, and further has either of a function of being injected with an electron from a cathode and a function of transporting an electron as required.

The electron transport layer and the hole transport layer are collectively called a charge transport layer. The electron injection layer and the hole injection layer are collectively called a charge injection layer.

The organic light emitting device of the present invention may be configured such that the organic light emitting device normally further has a substrate as an optional component, and the above-mentioned cathode, anode, functional layer and light emitting layer, as well as other optional components as required are provided on the surface of the substrate.

In one embodiment of the organic light emitting device of the present invention, usually, an anode is provided on a substrate, a functional layer and a light emitting layer are laminated as upper layers thereof, and further a cathode is laminated as an upper layer thereof. In a possible modification, a cathode is provided on a substrate, and an anode is provided as an upper layer of a functional layer and a light emitting layer.

In another possible modification, the organic light emitting device is a polymer light emitting device of any of a so-called bottom emission type of lighting from the substrate side, a so-called top emission type of lighting from the side

opposite to a substrate, and a double-sided lighting type. In still another possible modification, layers having other functions, such as any protective film, buffer film and reflection layer, are provided. The polymer light emitting device is further covered with a sealing film or a sealing substrate to form a polymer light emitting apparatus with the polymer light emitting device shielded from external air.

Examples of the specific layer constitution of organic light emitting device of the present invention include a layer constitution shown in the following (a) to (f). The symbol "/" denotes herein that the layers described on both sides thereof are laminated adjacently.

(a) anode/first functional layer/second functional layer/hole transport layer/light emitting layer/cathode
(b) anode/first functional layer/second functional layer/hole transport layer/light emitting layer/electron injection layer/cathode
(c) anode/ first functional layer/second functional layer/hole transport layer/light emitting layer/hole blocking layer/electron injection layer/cathode
(d) anode/ first functional layer/second functional layer/hole transport layer/light emitting layer/electron transport layer/cathode
(e) anode/ first functional layer/second functional layer/hole transport layer/light emitting layer/electron transport layer/electron injection layer/cathode
(f) anode/ first functional layer/second functional layer/hole transport layer/light emitting layer/hole blocking layer/electron transport layer/electron injection layer/cathode

The order and the number of layers to be laminated and the thickness of each layer may be used as appropriate in consideration of the light emitting efficiency and device life.

In another embodiment, an organic light emitting device of the present invention has an anode and a cathode, has between the anode and the cathode a light emitting layer containing a light emitting organic compound, and has between the anode and the light emitting layer a first functional layer containing a first organic compound and a second functional layer containing a second organic compound in this order from the anode side, wherein the first organic compound is an electron accepting organic compound, and the second organic compound is an organic compound having a fused ring in which not less than four benzene rings are fused.

In the organic light emitting device of the embodiment, the second functional layer may be in contact with the light emitting layer.

Examples of the specific layer configuration of the organic light emitting device of the present embodiment include a layer configuration omitting the hole transporting layer from the layer constitutions as shown in (a) to (f).

## 2. Materials forming Layers of Device

Materials of layers forming the organic light emitting device of the present invention and a method for formation thereof will now be described more specifically.

### <Anode>

As an anode of the organic light emitting device of the present invention, a metal oxide, a metal sulfide and a metallic thin film having a high electric conductivity can be used. Above all, one having a high transmittance can be suitably used. Specific examples of the material of an anode include films prepared by using electrically conductive glasses made of indium oxide, zinc oxide, tin oxide and composites thereof such as indium tin oxide (ITO) and indium zinc oxide, NESA, gold, platinum, silver and copper, with ITO, indium zinc oxide and tin oxide being preferable. Examples of a method for preparing an cathode include a vacuum deposition method, a sputtering method, an ion plating method, and a plating method.

The thickness of the anode may be selected as appropriate in consideration of light transmittance and electric conductivity, and is, for example, 10 nm to 10 $\mu$m, preferably 20 nm to 1 $\mu$m, further preferably 50 nm to 500 nm.

### <First Functional Layer>

A first functional layer employed in the organic light emitting device of the present invention contains a first organic compound. In a preferred embodiment, the first organic compound is an electron accepting organic compound.

The electron accepting organic compound means a compound which has a tendency to accept electron, and has a property to form a charge-transfer complex by the reaction with an electron donating compound.

Among the electron accepting organic compounds, a compound having an oxidation reduction half wave po-

tential $E^1_{1/2}$ which satisfies the following mathematical formula is preferred, from the viewpoint of improving hole injection performance from the anode.

[Mathematical Formula 1]

$$E^1_{1/2} \geqq +0.20\ [V]$$

The oxidation reduction half wave potential $E^1_{1/2}$ can be measured with the cyclic voltammetry (CV). The CV is measured in an acetonitrile solvent containing 0.1 mol/L of tetrabutylammonium tetrafluoroborate (TBA • BF4) as a supporting salt, by using a silver electrode as a reference electrode, using a carbon electrode as a working electrode and a coiled platinum electrode as a counter electrode, under a condition of 20 to 22°C in temperature and 10 to 20 mV/s in voltage sweeping rate.

The electron accepting organic compound employed in the present invention preferably has a cyano group, a halogen group or a nitro group, from the viewpoint of improving hole injection performance from the anode.

The electron accepting organic compound employed in the present invention is preferably a quinine derivative, from the viewpoint of improving hole injection performance from the anode.

The specific examples of the electron accepting compound include 2,3-dibromo-5,6-dicyano-p-benzoquinone, 2,3-diiodo-5,6-dicyano-p-benzoquinone, 2,3-dicyano -p-benzoquinone, 2,3,5,6-tetrafluoro-7,7,8,8-tetracyanoquinodimethane, trifluoromethyl-tetracyanoquinodimethane, 2,5-difluoro-tetracyanoquinodimethane, monofluoro-tetracyanoquinodimethane, tetracyanoquinodimethane, decyl-tetracyanoquinodimethane, 2,3-dicyano-5-nitro-1,4-naphthoquinone, 3,3,5,5-tetrabromo-diphenoquinone and 9-dicyanomethylene-2,4,5,7-tetranitro-fluorene.

Among them, 2,3,5,6-tetrafluoro-7,7,8,8-tetracyanoquinodimethane, trifluoromethyl-tetracyanoquinodimethane and tetracyanoquinodimethane are preferred from the viewpoint of improving hole injection performance from the anode.

As the method of film formation of the first functional layer employed in the organic light emitting device of the present invention, there can be used coating methods using a solution of the first functional layer components, such as a spin coating method, a casting method, a micro-gravure coating method, a gravure coating method, a bar coating method, a roll coating method, a wire bar coating method, a dip coating method, a spray coating method, a screen printing method, a flexographic printing method, an offset printing method and an inkjet printing method.

The thickness of the first functional layer, the optimum value of which varies according to a material used, may be selected so that the driving voltage and light emitting efficiency may become appropriate values, but at least a thickness at which no pin hole is produced is required, and too large a thickness is not preferable because the driving voltage of the device increases. The thickness of the functional layer is, for example, 1 nm to 1 μm, preferably 2 nm to 500 nm, further preferably 5 nm to 200 nm.

<Second Functional Layer>

A second functional layer employed in the organic light emitting device of the present invention contains a second organic compound. In a preferred embodiment, the second organic compound has a fused ring, or a plurality of, preferably not less than three aromatic rings. A conjugated electron system is present on the fused ring or the aromatic ring. Therefore, when the organic compound having a fused ring or a plurality of aromatic rings are present in contact with the second functional layer and the hole transport layer, the HOMO energy difference between the first organic compound and the hole transport organic compound is leveled, so that the energy barrier as the hole moves from the first functional layer to the hole transport layer is thought to become low.

The second organic compound preferably has a fused ring in which not less than four benzene rings are fused, and is more preferably a pentacene or a pentacene derivative, from the viewpoint of improving hole injection performance from the anode. The second organic compound preferably does not have substituents since the molecular frameworks are preferred to be present as close with each other as possible. Examples of the compounds preferred to be employed as the second organic compound are as follows.

Examples of the second organic compound include pyrene, pyrene derivatives, chrysene, chrysene derivatives, tetraphene, tetraphene derivatives, tetracene, tetracene derivatives, picene, picene derivatives, pentaphene, pentaphene derivatives, pentacene, pentacene derivatives, hexaphene, hexaphene derivatives, hexacene, hexacene derivatives, coronene, coronene derivatives, trinaphthylene, trinaphthylene derivatives, heptaphene, heptaphene derivatives, heptacene, heptacene derivatives, pyranthrene, pyranthrene derivatives, octaphene, octaphene derivatives, octacene, octacene derivatives, nonaphene, nonaphene derivatives, nonacene, nonacene derivatives, ovalene, ovalene derivatives,

decaphene, decaphene derivatives, decacene and decacene derivatives.

Among them, preferred second organic compounds are pentacene and pentacene derivatives.

As the method of film formation of the second functional layer employed in the organic light emitting device of the present invention, there can be used coating methods using a solution of the second functional layer components, such as a spin coating method, a casting method, a micro-gravure coating method, a gravure coating method, a bar coating method, a roll coating method, a wire bar coating method, a dip coating method, a spray coating method, a screen printing method, a flexographic printing method, an offset printing method and an inkjet printing method.

The thickness of the first functional layer, the optimum value of which varies according to a material used, may be selected so that the driving voltage and light emitting efficiency may become appropriate values, but at least a thickness at which no pin hole is produced is required, and too large a thickness is not preferable because the driving voltage of the device increases. The thickness of the functional layer is, for example, 1 nm to 1 μm, preferably 2 nm to 500 nm, further preferably 5 nm to 200 nm.

<Hole Transport Layer>

A hole transport layer employed in the organic light emitting device of the present invention contains a hole transport material. The hole transport material is not particularly limited as long as it is an organe compound which performs a hole transport function. Specific examples of the organic compound include polyvinyl carbazole or derivatives thereof, polysilane or derivatives thereof, polysiloxane derivatives having an aromatic amine on a side chain or a main chain, pyrazoline derivatives, arylamine derivatives, stilbene derivatives, triphenyldiamine derivatives, polyaniline or derivatives thereof, polythiophene or derivatives thereof, polypyrrole or derivatives thereof, polyarylamine or derivatives thereof, poly(p-phenylenevinylene) or derivatives thereof, polyfluorene derivatives, polymer compounds having an aromatic amine residue, and poly(2,5-thienylenevinylene) or derivatives thereof.

The organic compound is preferably a polymeric compound, for example, a polymer. This is because if the organic compound is a polymeric compound, processability for forming a film is improved, and the light emitting performance of the organic light emitting device is homogenized. For example, the organic compound has a polystyrene-equivalent number average molecular weight of 10000 or more, preferably $3.0 \times 10^4$ to $5.0 \times 10^5$, more preferably $6.0 \times 10^4$ to $1.2 \times 10^5$. The organic compound has a polystyrene-equivalent weight average molecular weight of $1.0 \times 10^4$ or more, preferably $5.0 \times 10^4$ to $1.0 \times 10^6$, more preferably $1.0 \times 10^5$ to $6.0 \times 10^5$.

Specific examples include the hole transport materials contained in the hole transport layer include those described in JP 63-70257 A, JP 63-175860 A, JP 2-135359 A, JP 2-135361 A, JP 2-209988 A, JP 3-37992 A and JP 3-152184 A.

Among them, the hole transport organic compound are preferably polymeric hole transport materials such as polyvinyl carbazole or derivatives thereof, polysilane or derivatives thereof, polysiloxane derivatives having an aromatic amine compound group on a side chain or a main chain, polyaniline or derivatives thereof, polythiophene or derivatives thereof, polyfluorene derivatives, polymer compounds having an aromatic amine residue, poly(p-phenylenevinylene) or derivatives thereof and poly(2,5-thienylenevinylene) or derivatives thereof, further preferably polyvinyl carbazole or derivatives thereof, polysilane or derivatives thereof, polysiloxane derivatives having an aromatic amine on a side chain or a main chain, polyfluorene derivatives, polymer compounds having an aromatic amine residue. When the hole transport organic compound is a low molecular compound, it is preferably dispersed in a polymer binder and used.

Polyvinyl carbazole or a derivative thereof is obtained by, for example, carrying out cationic polymerization or radical polymerization from a vinyl monomer.

Examples of polysilane or a derivative thereof include compounds described in Chemical Review (Chem. Rev.), Vol. 89, page 1359 (1989) and British Patent No. GB 2300196 Publication. For the synthesis method, methods described in these documents can be used, but particularly a Kipping method is suitably used.

For polysiloxane or derivatives thereof, those having a structure of the above-mentioned low molecular hole transport material on a side chain or a main chain are suitably used because the siloxane backbone structure has little hole transport performance. Particularly, mention is made of those having a hole transport aromatic amine on a side chain or a main chain.

The hole transport organic compound is preferably a polymer having a fluorenediyl group represented by formula (1). This is because when the hole transport organic compound is in contact with the organic compound having a fused ring or a plurality of aromatic rings to form a hole transport layer of the organic light emitting device, hole injection efficiency is improved to increase the current density at the time of driving.

In formula (1), the substituent that may be possessed by an aryl group and a monovalent heterocyclic group is preferably an alkyl group, an alkyloxy group or an aryl group, more preferably an alkyl group, from the viewpoint of solubility of the organic compound. Examples of the alkyl group include a methyl group, an ethyl group, a propyl group, an isopropyl group, a butyl group, an isobutyl group, a tert-butyl group, a sec-butyl group, a pentyl group, a hexyl group, a heptyl group and an octyl group. Examples of the alkyloxy group include a methoxy group, an ethoxy group, a propyloxy

group, an isopropyloxy group, a butyloxy group, an isobutyloxy group, a tert-butyloxy group, a sec-butyloxy group, a pentyloxy group, a hexyloxy group, a pentyloxy group and a hexyloxy group. Examples of the aryl group include a phenyl group and a naphthyl group, and examples of the monovalent heterocyclic group include a pyridyl group. These groups may have a substituent.

Specific examples of the preferred fluorenediyl group are shown below.

[Chemical Formula 3]

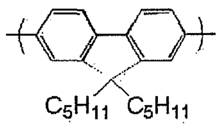
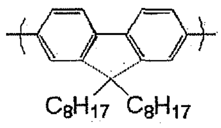
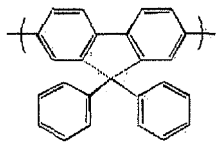
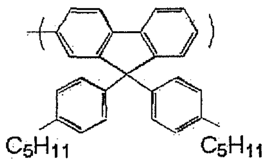
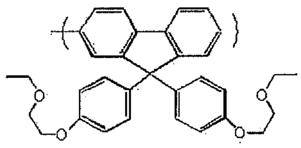
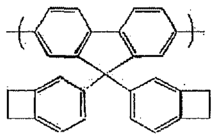

Above all, especially preferable hole transport organic compounds are polymers containing the fluorenediyl group and a structure of an aromatic tertiary amine compound as a repeating unit, for example, polyarylamine-based polymers.

Examples of the repeating unit containing a structure of an aromatic tertiary amine compound include repeating units represented by formula (2).

In formula (2), the hydrogen atom on the aromatic ring may have been substituted by a substituent selected from a halogen atom, an alkyl group, an alkyloxy group, an alkylthio group, an aryl group, an aryloxy group, an arylthio group, an arylalkyl group, an arylalkyloxy group, an arylalkylthio group, an alkenyl group, an alkynyl group, an arylalkenyl group, an arylalkynyl group, an acyl group, an acyloxy group, an amide group, an acid imide group, an imine residue, a substituted amino group, a substituted silyl group, a substituted silyloxy group, a substituted silylthio group, a substituted silylamino group, a cyano group, a nitro group, a monovalent heterocyclic group, a heteroaryloxy group, a heteroarylthio group, an alkyloxycarbonyl group, an aryloxycarbonyl group, an arylaklyloxycarbonyl group, a heteroaryloxycarbonyl group, a carboxyl group and so on.

The substituent may be a crosslinking group such as a vinyl group, an ethynyl group, a butenyl group, a group having an acrylic structure, a group having an acrylate structure, a group having an acrylamide structure, a group having a methacrylic structure, a group having a methacrylate structure, a group having a methacrylamide structure, a group having a vinylether structure, a vinylamino group, a group having a silanol structure, a group having a small ring (for example, cyclopropane, cyclobutane, epoxy, oxetane, diketene, and episulfide), a group having a lactone structure, a group having a lactam structure or a group having a structure of a siloxane derivative. In addition to the groups described above, a combination of groups capable of forming an ester bond and an amide bond (for example, a group having an ester structure and an amino group, a group having an ester structure and a hydroxyl group, etc.) and so on can be used as a crosslinking group.

A carbon atom in $Ar^2$ and a carbon atom in $Ar^3$ may be bonded to each other directly or may be bonded via a divalent group such as -O- or -S-.

Examples of the arylene group include a phenylene group, examples of the divalent heterocyclic group include a pyridinediyl group, and these groups may have a substituent.

Examples of the aryl group include a phenyl group and a naphthyl group, examples of the monovalent heterocyclic group include a pyridyl group, and these groups may have a substituent.

Examples of the monovalent heterocyclic group include a thienyl group, a furyl group and a pyridyl group.

The substituent that may be possessed by an arylene group, an aryl group, a divalent heterocyclic group and a monovalent heterocyclic group is preferably an alkyl group, an alkyloxy group or an aryl group, more preferably an alkyl group, from the viewpoint of the solubility of the polymer compound. Examples of the alkyl group include a methyl group, an ethyl group, a propyl group, an isopropyl group, a butyl group, an isobutyl group, a tert-butyl group, a sec-butyl group, a pentyl group, a hexyl group, a heptyl group and an octyl group. Examples of the alkyloxy group include a methoxy group, an ethoxy group, a propyloxy group, an isopropyloxy group, a butyloxy group, an isobutyloxy group, a tert-butyloxy group, a sec-butyloxy group, a pentyloxy group, a hexyloxy group, a pentyloxy group and a hexyloxy group.

$Ar^1$ to $Ar^4$ are preferably arylene groups, more preferably phenylene groups. $Ar^5$ to $Ar^7$ are preferably aryl

groups, more preferably phenyl groups.

m and n are preferably 0 from the viewpoint of ease of synthesis of a monomer.

Specific examples of the repeating unit represented by formula (2) include repeating units shown below.

[Chemical Formula 4]

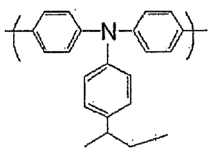
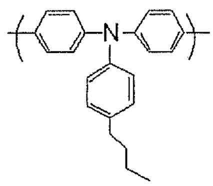
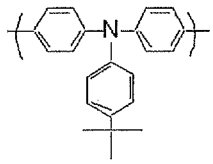
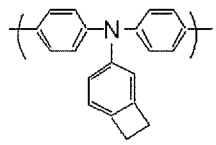
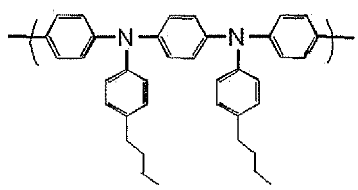
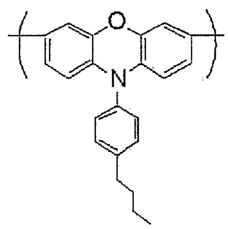
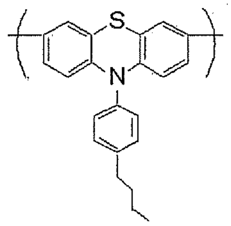

The method for forming a hole transport layer is not limited, and when the hole transport organic compound is a low molecular compound, mention is made of a method by film formation from a mixed solution with a polymer binder. When the hole transport organic compound is a polymer, mention is made of a method by film formation from a solution.

The solvent used for film formation from a solution is not particularly limited as long as it dissolves a hole transport material. Examples of the solvent include chlorine-containing solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

As the method of film formation from a solution, there can be used coating methods such as a spin coating method, a casting method, a micro-gravure coating method, a gravure coating method, a bar coating method, a roll coating method, a wire bar coating method, a dip coating method, a spray coating method, a screen printing method, a flexographic printing method, an offset printing method and an inkjet printing method.

The polymer binder to be mixed is preferably one that does not extremely hinder charge transportation, and one that does not have strong absorption of visible light is suitably used. Examples of the polymer binder include polycarbonate, polyacrylate, polymethyl acrylate, polymethyl methacrylate, polystyrene, polyvinyl chloride, and polysiloxane.

The thickness of the hole transport layer, the optimum value of which varies according to a material used, may be selected so that the driving voltage and light emitting efficiency may become appropriate values, but at least a thickness at which no pin hole is produced is required, and too large a thickness is not preferable because the driving voltage of the device increases. The thickness of the hole transport layer is, for example, 1 nm to 1 $\mu$m, preferably 2 nm to 500 nm, further preferably 5 nm to 200 nm.

<Light Emitting Layer>

The light emitting layer of the organic light emitting device of the present invention is a layer containing a material that can be caused to emit light by electrifying an anode and a cathode, or applying a voltage thereto. The light emitting layer material used for the light emitting layer may be a material that can be caused to emit light by electrifying or applying a voltage, and is not particularly limited, but is preferably an organic electroluminescent (EL) material or an inorganic EL material.

The organic EL material may be an organic material that can be caused to emit light by passing a current, and is not particularly limited, but a known material can be appropriately used. Examples of the organic EL material include a distyrylbiphenyl-based material, a dimesitylboryl-based material, a stilbene-based material, a dipyridyldicyanobenzene material, a benzoxazole-based material, a distyryl-based material, a carbazole-based material, a dibenzochrysene-based material, an arylamine-based material, a pyrene-substituted oligothiophene-based material, a para-phenylenevinylene (PPV) oligomer-based material, a carbazole-based material and a polyfluorene-based material.

The organic EL material is preferably a light emitting polymeric compound, for example a light emitting polymer. If the organic EL material is a polymeric compound, processability for forming a film is improved, so that the light emitting performance of the organic light emitting device is equalized. For example, the light emitting polymer compound has a polystyrene-equivalent number average molecular weight of 10000 or more, preferably $5.0 \times 10^4$ to $1.0 \times 10^6$, more preferably $1.0 \times 10^5$ to $6.0 \times 10^5$. The light emitting polymer compound has a polystyrene-equivalent weight average molecular weight of $1.0 \times 10^4$ or more, preferably $1.0 \times 10^5$ to $5.0 \times 10^6$, more preferably $4.0 \times 10^5$ to $1.0 \times 10^6$.

Examples of the light emitting polymer compound include polyfluorene, and derivatives and copolymers thereof, polyarylene, and derivatives and copolymers thereof, polyarylenevinylene, and derivatives and copolymers thereof, and (co)polymers of aromatic amine and derivatives thereof as disclosed in WO 97/09394, WO 98/27136, WO 99/54385, WO 00/22027, WO 01/19834, GB 2340304 A, GB 2348316, US 573636, US 5741921, US 5777070, EP 0707020, JP 9-111233 A, JP 10-324870 A, JP 2000-80167 A, JP 2001-123156 A, JP 2004-168999 A, JP 2007-162009 A, "Development and Constituent Materials of Organic EL Device (CMC Publishing CO., LTD. 2006) and so on.

The light emitting polymer compound is preferably a polymer having a fluorenediyl group represented by formula (1). More preferable are a dialkylfluorene-based polymer, wherein $R^1$ and $R^2$ in formula (1) are each independently an alkyl group, a phenylfluorene-based polymer, wherein one of $R^1$ and $R^2$ in formula (1) is a phenyl group that may have a substituent, and the other one of $R^1$ and $R^2$ is an aryl group (other than a phenyl group) that may have a substituent, and a diphenylfluorene-based polymer, wherein $R^1$ and $R^2$ in formula (1) are each independently a phenyl group that may have a substituent. This is because they have an excellent electron transport function.

Above all, a preferred light emitting polymeric compound is a polymer having as a repeating unit a fluorenediyl group represented by formula (1) and a repeating unit represented by formula (2). This is because the probability of recombination of an electron and a hole in the light emitting layer is increased by a fluorenediyl group having an excellent electron transport function and an amine structure having an excellent hole transport function, so that light emitting efficiency is improved.

Examples of the polymer described above include phenylenediamine-based polymers, triphenylamine-based polymers and diphenylamine-based polymers. The structures thereof will be described more specifically below. In the descriptions provided below, it is meant that the phenyl group, the phenylene group, the aryl group and the arylene group may have a substituent.

(i) Phenylenediamine-based Polymer

That is, the phenylenediamine-based polymer is the abovementioned polymer, wherein one of $Ar^2$ and $Ar^4$ is a phenylene group, the other one of $Ar^2$ and $Ar^4$ is an arylene group (other than a phenylene group), $Ar^1$ and $Ar^3$ are each independently an arylene group, and $Ar^5$, $Ar^6$ and $Ar^7$ are each independently an aryl group, in formula (2).

(ii) Triphenylamine-based Polymer

That is, the triphenylamine-based polymer is the above-mentioned polymer, wherein all of $Ar^1$, $Ar^2$ and $Ar^4$ have a phenylene group, the above-mentioned polymer, wherein each of $Ar^2$ and $Ar^3$ is a phenylene group, and $Ar^5$ has a phenyl group, or the above-mentioned polymer, wherein $Ar^4$ is a phenylene group, and each of $Ar^6$ and $Ar^7$ is a phenyl group, in each case in formula (2).

(iii) Diphenylamine-based Polymer

That is, the diphenylamine-based polymer is the above-mentioned polymer, wherein any two of $Ar^1$, $Ar^2$ and $Ar^4$ are phenylene groups, and the other is an arylene group (other than a phenylene group), the above-mentioned polymer, wherein any two of $Ar^2$, $Ar^3$ and $Ar^5$ are a phenylene group for $Ar^2$ and $Ar^3$ and a phenyl group for $Ar^5$, and the other is an arylene group (other than a phenylene group) when it is $Ar^2$ or $Ar^3$, or an aryl group (other than a phenyl group) when it is $Ar^5$, or the above-mentioned polymer, wherein any two of $Ar^4$, $Ar^6$ and $Ar^7$ are a phenylene group for $Ar^4$ and a phenyl group for $Ar^6$ and $Ar^7$, and the other is an arylene group (other than a phenylene group) when it is $Ar^4$, or an aryl group (other than a phenyl group) if it is $Ar^6$ or $Ar^7$.

As the inorganic EL material, it may be a material that can be caused to emit light by applying a voltage without particular limitation, a well-known material can be appropriately used, and for example, GaN doped with Mg, ZnS doped with Mn, and SrS doped with Ce can be used.

The thickness of the light emitting layer is not particularly limited, and can be appropriately changed according to intended design, but is preferably about 10 to 200 nm. If the thickness is less than the above-mentioned lower limit, there are tendencies where an electron and a hole are not adequately combined with each other, where luminance is not adequate, and where production becomes difficult. On the other hand, if the thickness is more than the above-mentioned upper limit, a voltage applied tends to increase.

<Electron Transport Layer>

As the electron transport layer that may be possessed by the organic light emitting device of the present invention, a known one can be used, and examples thereof include oxadiazole derivatives, anthraquinodimethane or derivatives thereof, benzoquinone or derivatives thereof, naphthoquinone or derivatives thereof, anthraquinone or derivatives thereof, tetracyanoanthraquinonedimethane or derivatives thereof, fluorenone derivatives, diphenyldicyanoethylene or derivatives thereof, diphenoquinone derivatives, metal complexes of 8-hydroxyquinoline or derivatives thereof, polyquinoline or derivatives thereof, polyquinoxaline or derivatives thereof, and polyfluorene or derivatives thereof.

Specific examples include those described in JP 63-70257 A, JP 63-175860 A, JP 2-135359 A, JP 2-135361 A, JP 2-209988 A, JP 3-37992 A, and JP 3-152184 A.

Among them, preferable are oxadiazole derivatives, benzoquinone or derivatives thereof, anthraquinone or derivatives thereof, or metal complexes of 8-hydroxyquinoline or derivatives thereof, polyquinoline or derivatives thereof, polyquinoxaline or derivatives thereof and polyfluorene or derivatives thereof, and further preferable are 2-(4-biphenylyl)-5-(4-tert-butylphenyl)-1,3,4-oxadiazole, benzoquinone, anthraquinone, tris(8-quinolinol) aluminum and polyquinoline.

The method for forming an electron transport layer is not particularly limited, and examples thereof are a method of vacuum vapor deposition from a powder or a method by film formation from a solution or a molten state for a low molecular electron transport material, and a method by film formation from a solution or a molten state for a polymer electron transport material. For film formation from a solution or a molten state, a polymer binder may be used in combination.

The solvent to be used for film formation from a solution is not particularly limited as long as it dissolves an electron transport material and/or a polymer binder. Examples of the solvent include chlorine-containing solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

As the method of film formation from a solution or a molten state, there can be used coating methods such as a spin coating method, a casting method, a micro-gravure coating method, a gravure coating method, a bar coating method, a roll coating method, a wire bar coating method, a dip coating method, a spray coating method, a screen printing method, a flexographic printing method, an offset printing method and an inkjet printing method.

The polymer binder to be mixed is preferably one that does not extremely hinder charge transportation, and one that does not have strong absorption of visible light is suitably used. Examples of the polymer binder include poly(N-vinylcarbazole), polyaniline or derivatives thereof, polythiophene or derivatives thereof, poly(p-phenylenevinylene) or derivatives thereof, poly(2,5-thienylenevinylene) or derivatives thereof, polycarbonate, polyacrylate, polymethylacrylate, polymethylmethacrylate, polystyrene, polyvinyl chloride, and polysiloxane.

The thickness of the electron transport layer, the optimum value of which varies according to a material used, may be selected so that the driving voltage and light emitting efficiency may become appropriate values, but at least a thickness at which no pin hole is produced is required, and too large a thickness is not preferable because the driving voltage of the device increases. The thickness of the electron transport layer is, for example, 1 nm to 1 μm, preferably 2 nm to 500 nm, further preferably 5 nm to 200 nm.

<Electron Injection Layer>

For the electron injection layer that may be possessed by the organic light emitting device of the present invention, an optimum material is appropriately selected according to the type of the light emitting layer, and examples thereof include an alkali metal, an alkali earth metal, an alloy containing at least one of an alkali metal and an alkali earth metal, an oxide of an alkali metal or an alkali earth metal, a halide, a carbonate or a mixture of these substances. Examples of the alkali metal, the oxide of an alkali metal, the halide and the carbonate include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride and lithium carbonate. Examples of the alkali earth metal, the oxide of an alkali earth metal, the halide and the carbonate include magnesium, calcium, barium, strontium, magnesium oxide, magnesium fluoride, calcium oxide, calcium fluoride, barium oxide, barium fluoride, strontium oxide, strontium fluoride and magnesium carbonate. The electron injection layer may be made of a laminate of two or more layers, and examples thereof include LiF/Ca. The electron injection layer is formed by a vapor deposition method, a sputtering method, a printing method or the like.

The thickness of the electron injection layer is preferably about 1 nm to 1 μm.

<Hole Blocking Layer>

As the hole blocking layer that may be possessed by the organic light emitting device of the present invention,

known one can be used, and examples thereof include oxadiazole derivatives, anthraquinodimethane or derivatives thereof, benzoquinone or derivatives thereof, naphthoquinone or derivatives thereof, anthraquinone or derivatives thereof, tetracyanoanthraquinonedimethane or derivatives thereof, fluorenone derivatives, diphenyldicyanoethylene or derivatives thereof, diphenoquinone derivatives, metal complexes of 8-hydroxyquinoline or derivatives thereof, polyquinoline or derivatives thereof, polyquinoxaline or derivatives thereof, and polyfluorene or derivatives thereof. The hole blocking layer is a layer having a function of blocking transportation of a hole. When the electron injection layer and/or the electron transport layer have a function of blocking transportation of a hole, these layers may also serve as a hole blocking layer. It can be confirmed that the hole blocking layer has a function of blocking transportation of a hole by, for example, preparing a device for allowing only a hole current to pass. For example, it can be confirmed that the hole blocking layer shows a function of blocking transportation of a hole by preparing a device having no hole blocking layer and allowing only a hole current to pass, and a device constituted by inserting a hole blocking layer into the above-mentioned device, and determining a decrease in current value of the device having a hole blocking layer.

<Cathode>

For the cathode of the organic light emitting device of the present invention, a material having a small work function, allowing easy injection of an electron into a light emitting layer is preferable. For example, lithium, sodium, potassium, rubidium, cesium, beryllium, magnesium, calcium, strontium, barium, aluminum, scandium, vanadium, zinc, yttrium, indium, cerium, samarium, europium, terbium, or ytterbium, or an alloy of two or more of the above-mentioned metals, or an alloy of one or more of the above-mentioned metals with one or more of gold, silver, platinum, copper, manganese, titanium, cobalt, nickel, tungsten and tin, graphite, a graphite intercalation compound or the like is used. Examples of the alloy may include a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The cathode may be arranged to a laminate constitution which has two or more layers. Examples of the laminate constitution include laminate constitutions of the above described metals, metal oxides, fluorides and alloys thereof, with metals such as aluminum, silver, chromium and the like.

The thickness of the cathode may be selected as appropriate in consideration of electric conductivity and durability, but is, for example, 10 nm to 10 $\mu$m, preferably 20 nm to 1 $\mu$m, further preferably 50 nm to 500 nm.

As a method for preparing a cathode, a vacuum deposition method, a sputtering method, a lamination method of thermocompression-bonding a metal thin film, or the like is used.

3. Method for Producing Device

The method for producing the organic light emitting device of the present invention is not particularly limited, and the organic light emitting device can be produced by sequentially laminating layers on a substrate. Specifically, the organic light emitting device can be produced by providing an anode on a substrate, providing thereon layers such as a functional layer and a hole transport layer, providing thereon a light emitting layer, providing thereon layers such as an electron transport layer and an electron injection layer as required, and further laminating thereon a cathode.

4. Applications of Device

The organic light emitting device produced with the method of the present invention is not particularly limited for its applications, but can be used for a light source for illumination, a light source for signs, a light source for backlight, a display device, a printer head and so on. For the display device, a known drive technique and a known drive circuit are used, and a constitution of segment type, dot matrix type or the like can be selected.

EXAMPLES

Hereinbelow, examples will be provided for describing the present invention more in detail, but the present invention is not limited thereto.

(Number Average Molecular Weight and Weight Average Molecular Weight)

For the polystyrene-equivalent number average molecular weight and the polystyrene-equivalent weight average molecular weight of a polymer, the polystyrene-equivalent number average molecular weight and the polystyrene-equivalent weight average molecular weight were determined by GPC ("LC-10 Avp" manufactured by Shimadzu Corporation). A polymer to be measured was dissolved in tetrahydrofuran so as to have a concentration of about 0.5 wt%,

and the solution was injected into GPC in an amount of 50 μL. Tetrahydrofuran was used for a mobile phase of GPC, and made to flow at a flow rate of 0.6 mL/min. For a column, two pieces of "TSKgel SuperHM-H" (manufactured by TOSOH CORPORATION) and a piece of "TSKgel SuperH 2000" (manufactured by TOSOH CORPORATION) were connected in series. For a detector, a differential refractive index detector ("RID-10A" manufactured by Shimadzu Corporation) was used.

Synthesis Example 1

(Synthesis of Polymer A (Hole Transport Polymer Compound))

To a flask to which a Dimroth was connected were added 5.25 g (9.9 mmol) of compound 1 represented by formula:
[Chemical formula 5]

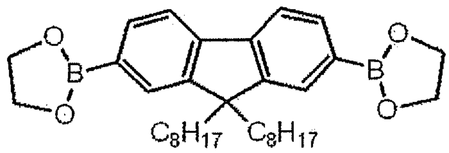

,

4.55 g (9.9 mmol) of compound 2 represented by formula:
[Chemical Formula 6]

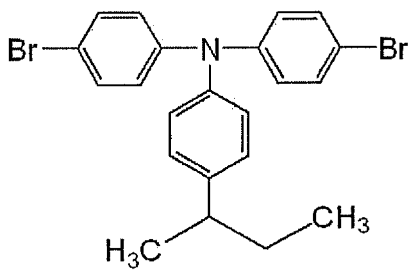

,

0.91 g of methyltrioctylammonium chloride (trade name: Aliquat 336 (registered trademark) manufactured by Aldrich) and 69 mL of toluene to obtain a monomer solution. Under a nitrogen atmosphere, the monomer solution was heated, and 2 mg of palladium acetate and 15 mg of tris(2-methylphenyl)phosphine were added at 80°C. To the obtained monomer solution was added 9.8 g of a 17.5 wt% aqueous sodium carbonate solution, and the resulting mixture was then stirred at 110°C for 19 hours. Thereto was added 121 mg of phenylboric acid dissolved in 1.6 mL of toluene, and the resulting mixture was stirred at 105°C for an hour.

The organic layer was separated from the aqueous layer, and 300 mL of toluene was then added to the organic layer. The organic layer was washed with 40 mL of a 3 wt% aqueous acetic acid solution (2x) and 100 mL of ion-exchanged water (1×) in this order, and separated from the aqueous layer. To the organic layer were added 0.44 g of sodium N, N-diethyldithiocarbamate trihydrate and 12 mL of toluene, and the resulting mixture was stirred at 65°C for 4 hours.

A solution of the obtained reaction product in toluene was passed through a silica gel/alumina column through which toluene had been passed in advance, the obtained solution was added dropwise to 1400 mL of methanol, a precipitate was resultantly generated, and this precipitate was filtered and dried to obtain a solid. This solid was dissolved in 400 mL of toluene, the resulting solution was added dropwise to 1400 mL of methanol, a precipitate was resultantly generated, and this precipitate was filtered and dried to obtain 6.33 g of a polymer (hereinafter, referred to as a "polymer A"). The polystyrene-equivalent number average molecular weight Mn of the polymer A was $8.8 \times 10^4$, and the polystyrene-equivalent weight average molecular weight Mw was $3.2 \times 10^5$.

It is presumed from the charge stock that the polymer A is a polymer having repeating units represented by:

[Chemical Formula 7]

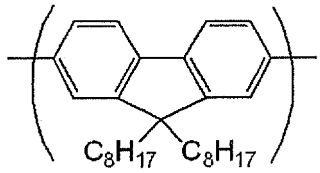

and

**[0131]**

[Chemical Formula 8]

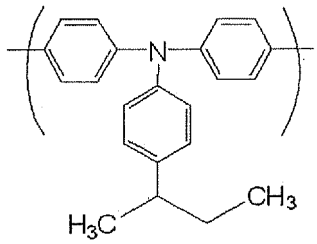

in a ratio of 1:1 (molar ratio).

Synthesis Example 2

(Synthesis of Polymer B (Light Emitting Polymer Compound))

To a 200 mL separable flask to which a Dimroth was connected were added 3.18 g (6.0 mmol) of 9,9-dioctylfluorene-2,7-diboric acid ethylene glycol ester, 3.06 g (5.4 mmol) of 9,9-dioctyl-2,7-dibromofluorene, 0.44 g (0.6 mmol) of N,N-bis(4-bromophenyl)-N,N'-bis(2,6-dibromo-4-tert-butylphenyl)-1,4-phenylenediamine, 0.82 g of methyltrioctylammonium chloride (trade name: Aliquat 336 (registered trademark) manufactured by Aldrich) and 60 mL of toluene. Under a nitrogen atmosphere, 4.2 mg of bistriphenylphosphinepalladium dichloride was added, and the resulting mixture was heated to 85°C. The obtained solution was heated to 105°C while adding 16.3 mL of a 17.5 wt% aqueous sodium carbonate solution dropwise thereto, and the resulting mixture was stirred for 1.5 hours. Next, 0.74 g of phenylboric acid, 4.2 mg of bistriphenylphosphinepalladium dichloride and 30 mL of toluene were added, and the resulting mixture was stirred at 105°C for 17 hours.

The aqueous layer was removed from the obtained solution, 3.65 g of sodium N,N-diethyldithiocarbamate trihydrate and 36 mL of ion-exchanged water were then added, and the resulting mixture was stirred at 85°C for 2 hours. The organic layer was separated from the aqueous layer, and the organic layer was then washed with 80 mL of ion-exchanged water (2x), 80 mL of a 3 wt% aqueous acetic acid solution (2x) and 80 mL of ion-exchanged water (2x) in this order.

The organic layer was added dropwise to 930 mL of methanol to precipitate a polymer, and the precipitate was filtered, and then dried to obtain a solid. This solid was dissolved in 190 mL of toluene, the solution was passed through a silica gel/alumina column through which toluene had been passed in advance, this solution was added dropwise to 930 mL of methanol to precipitate a polymer, and the precipitate was filtered, and then dried to obtain 4.17 g of a polymer B represented by formula:

[Chemical Formula 9]

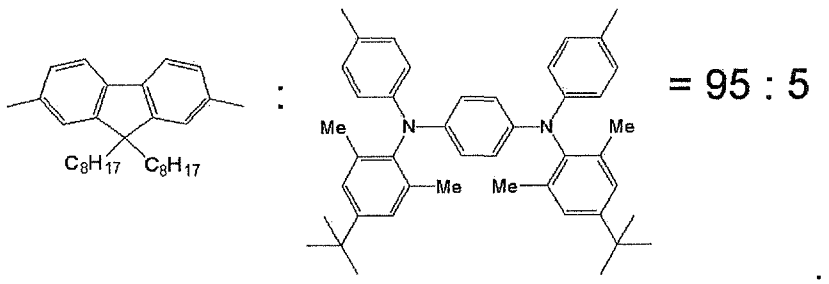

The polystyrene-equivalent number average molecular weight Mn of this polymer B was 2.7 × $10^5$, and the polystyrene-equivalent weight average molecular weight Mw was 7.1 × $10^5$.

Example 1

(Production of Organic Light Emitting Device 1)

Fig. 1 is a schematic cross-sectional view showing the structure of an organic EL device that is one embodiment of the present invention.

2,3,5,7-Tetrafluoro-7,7,8,8-tetracyanoquinodimethane, an electron accepting organic compound, was dissolved in an acetonitrile solvent in a concentration by weight of 1% to prepare organic compound solution 1. Pentacene, a compound having a fused ring, was then dissolved in a tetrahydrofuran solvent in a concentration by weight of 0.5% to prepare organic compound solution 2.

On a glass substrate 11, an ITO film was deposited as an anode 12 in a thickness of 150 nm by a sputtering method. To the ITO film, the organic compound solution 1 was applied by a spin coating method to form an organic film, and the organic film was heat treated in the air at 200°C for 10 minutes to prepare a first functional layer 13, a hole injection layer. The organic compound solution 2 was then applied to the first functional layer by a spin coating method to form an organic film, and the organic film was heat treated under a nitrogen atmosphere at 150°C for 10 minutes to prepare a second functional layer 14, a hole transport layer. The solution of polymer A prepared by dissolving polymer A into a xylene solvent in a concentration of 0.8% by weight was applied to the second functional layer by a spin coating method to form an organic film of about 20 nm in thickness. Thereafter, the organic film was heat-treated under a nitrogen atmosphere on a hot plate at 180°C for 60 minutes to form a hole transport layer 15 which contains polymer A.

Next, a solution of the polymer B in which the polymer B was dissolved in a xylene solvent at a concentration of 1.5% by weight was applied to the hole transport layer containing polymer A by a spin coating method to form an organic film in a thickness of about 80 nm. This organic film was dried under a nitrogen gas atmosphere at 130°C for 10 minutes to form a light emitting layer 16 which contains polymer B. Thereafter, barium was deposited in a thickness of about 5 nm as a first cathode layer 17, and aluminum was then deposited in a thickness of about 80 nm as a second cathode layer 18 to form a cathode 19 having a two-layer constitution. Further, after the degree of vacuum reached 1 × $10^{-4}$ Pa or less, deposition of a metal was started. The obtained organic light emitting device is referred to as an "organic light emitting device 1".

When a voltage was applied to the organic light emitting device 1, current density was 88.4 mA/$cm^2$ as 8 V was applied.

Comparative Example 1

(Production of Organic Light Emitting Device 2)

An organic light emitting device was prepared in the same manner as in Example 1, except that the first functional layer and the second functional layer were not formed, and that between an ITO film and a layer containing the polymer A, a layer was formed by applying a solution of poly(ethylenedioxythiophene)/polystyrenesulfonic acid (Bayer, trade name: AI4083) (hereinafter, referred to as "AI4083") by a spin coating method to form an organic film in a thickness of 65 nm, and drying the film on a hot plate at 200°C for 10 minutes. The obtained organic light emitting device is referred to as an "organic light emitting device 2".

When a voltage was applied to the organic light emitting device 2, current density was 13.8 mA/$cm^2$ as 8 V was applied.

Comparative Example 2

(Production of Organic Light Emitting Device 3)

An organic light emitting device was prepared in the same manner as in Example 1, except that the second functional layer was not formed. The obtained organic light emitting device is referred to as an "organic light emitting device 3".

When a voltage was applied to the organic light emitting device 3, current density was 13.7 mA/$cm^2$ as 8 V was applied.

(Comparison of Current Density)

When a voltage of 8 V was applied to the organic light emitting devices 1, 2 and 3, current density of the organic light emitting device 1 was about 6.5 times as high as current density of the organic light emitting devices 2 and 3.

DESCRIPTION OF SYMBOLS

11 glass substrate
12 anode
13 first functional layer
14 second functional layer
15 hole transport layer
16 light emitting layer
17 first cathode layer
18 second cathode layer
19 cathode

## Claims

1. An organic light emitting device which has an anode and a cathode, has between the anode and the cathode a light emitting layer containing a light emitting organic compound, and has between the anode and the light emitting layer a first functional layer containing a first organic compound, a second functional layer containing a second organic compound and a hole transport layer in this order from the anode side, wherein the first organic compound is an electron accepting organic compound, and the second organic compound is an organic compound having a fused ring or not less than three aromatic rings.

2. The organic light emitting device according to claim 1, wherein the second organic compound has a fused ring in which not less than four benzene rings are fused.

3. An organic light emitting device which has an anode and a cathode, has between the anode and the cathode a light emitting layer containing a light emitting organic compound, and has between the anode and the light emitting layer a first functional layer containing a first organic compound and a second functional layer containing a second organic compound in this order from the anode side, wherein the first organic compound is an electron accepting organic compound, and the second organic compound is an organic compound having a fused ring in which not less than four benzene rings are fused.

4. The organic light emitting device according to any one of claims 1 to 3, wherein the electron accepting compound has a cyano group, a halogen group or a nitro group.

5. The organic light emitting device according to any one of claims 1 to 4, wherein the electron accepting compound is a quinine derivative.

6. The organic light emitting device according to any one of claims 1 to 5, wherein the second organic compound is pentacene.

7. The organic light emitting device according to any one of claims 1 to 6, wherein the light emitting organic compound is a light emitting polymeric compound.

8. The organic light emitting device according to claim 1 or 2, wherein the hole transport layer contains a polymer compound having a repeating unit represented by formula:

[Chemical Formula 1]

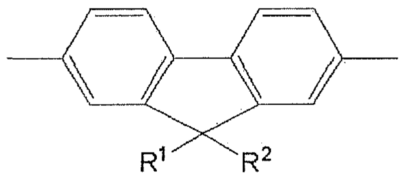

(1)

wherein $R^1$ and $R^2$ are the same or different and each represent an alkyl group, an aryl group that may have a substituent, or a monovalent heterocyclic group that may have a substituent; and a repeating unit represented by formula:

[Chemical Formula 2]

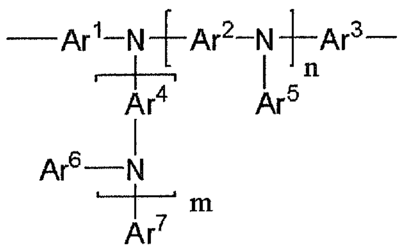

(2)

wherein $Ar^1$, $Ar^2$, $Ar^3$ and $Ar^4$ are the same or different and each represent an arylene group that may have a substituent, or a divalent heterocyclic group that may have a substituent, $Ar^5$, $Ar^6$ and $Ar^7$ each represent an aryl group that may have a substituent, or a monovalent heterocyclic group that may have a substituent, and n and m are the same or different and each represent 0 or 1; and when n is 0, a carbon atom contained in $Ar^1$ and a carbon atom contained in $Ar^3$ may be bonded to each other directly or may be bonded via an oxygen atom or a sulfur atom.

Figure 1

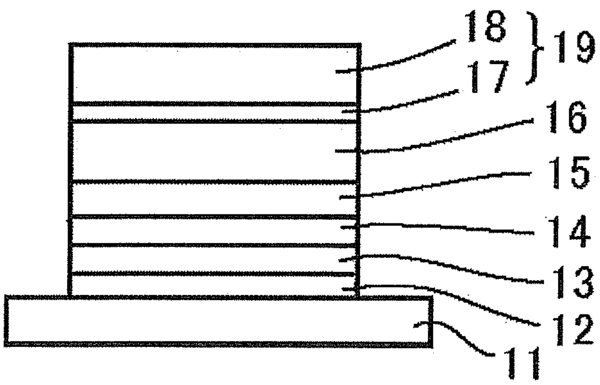

**INTERNATIONAL SEARCH REPORT**

International application No.
PCT/JP2011/059688

A. CLASSIFICATION OF SUBJECT MATTER
*H01L51/50*(2006.01)i, *C08G61/10*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C08G61/10, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2007-173780 A (Samsung SDI Co., Ltd.),<br>05 July 2007 (05.07.2007),<br>paragraphs [0030] to [0039]<br>& US 2007/0141396 A1 & EP 1801882 A2<br>& KR 10-2007-0065546 A & KR 10-2007-0068147 A<br>& CN 1988203 A | 1<br>4,5,7,8<br>2,3,6 |
| Y | JP 2000-252077 A (Matsushita Electric Industrial Co., Ltd.),<br>14 September 2000 (14.09.2000),<br>paragraph [0082]<br>(Family: none) | 4,5 |
| Y | WO 2005/064994 A1 (Fujifilm Corp.),<br>14 July 2005 (14.07.2005),<br>examples<br>& US 2008/0038583 A1 | 4,5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 23 May, 2011 (23.05.11) | 07 June, 2011 (07.06.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/059688

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2007-511636 A (Sumitomo Chemical Co., Ltd.), 10 May 2007 (10.05.2007), entire text; all drawings & US 2007/0096082 A1 & GB 2424897 A & WO 2005/052027 A1 & DE 112004002204 T & KR 10-2006-0100415 A & CN 1886443 A | 7,8 |
| Y | JP 2004-532314 A (Cambridge Display Technology Ltd.), 21 October 2004 (21.10.2004), claims 25, 27 & US 2004/0146743 A1 & GB 109108 D & GB 109108 D0 & EP 1377627 A & EP 2166582 A1 & WO 2002/083760 A2 & DE 60234756 D & AT 452156 T | 7,8 |
| A | WO 2009/084078 A1 (Pioneer Corp.), 09 July 2009 (09.07.2009), claim 10 & US 2010/0263727 A & EP 2226866 A1 | 1-8 |
| A | WO 2007/026703 A1 (Pioneer Corp.), 08 March 2007 (08.03.2007), paragraphs [0023] to [0025]; drawings & JP 2007-66626 A & US 2009/0136877 A1 | 1-8 |
| A | JP 7-106066 A (Sanyo Electric Co., Ltd.), 21 April 1995 (21.04.1995), claim 5 (Family: none) | 1-8 |
| A | WO 2007/043697 A1 (Pioneer Corp.), 19 April 2007 (19.04.2007), example 1 & US 2009/0135105 A1 | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001021104 A
- JP 63070257 A
- JP 63175860 A
- JP 2135359 A
- JP 2135361 A
- JP 2209988 A
- JP 3037992 A
- JP 3152184 A
- GB 2300196 A
- WO 9709394 A
- WO 9827136 A
- WO 9954385 A
- WO 0022027 A
- WO 0119834 A
- GB 2340304 A
- GB 2348316 A
- US 573636 A
- US 5741921 A
- US 5777070 A
- EP 0707020 A
- JP 9111233 A
- JP 10324870 A
- JP 2000080167 A
- JP 2001123156 A
- JP 2004168999 A
- JP 2007162009 A


### Non-patent literature cited in the description


- *Appl. Phys. Lett.,* 2004, vol. 84, 921
- *Chemical Review,* 1989, vol. 89, 1359
- Development and Constituent Materials of Organic EL Device. CMC Publishing CO., LTD, 2006